Europäisches Patentamt

European Patent Office

Office européen des brevets

(19)

(11) **EP 1 413 425 A1**

(12) **EUROPEAN PATENT APPLICATION**

(43) Date of publication:
**28.04.2004 Bulletin 2004/18**

(51) Int Cl.⁷: **B32B 3/10**, H05K 9/00

(21) Application number: **03023259.9**

(22) Date of filing: **14.10.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **21.10.2002 JP 2002305586**

(71) Applicant: **NISSHINBO INDUSTRIES, INC.**
**Tokyo 103 (JP)**

(72) Inventors:
• **Yoshida, Hiroshi, Research and Dev. Center Chiba-shi Chiba (JP)**
• **Banno, Koji, Research and Dev. Center Chiba-shi Chiba (JP)**
• **Kuwabara, Shin, Research and Dev. Center Chiba-shi Chiba (JP)**

(74) Representative: **Müller-Boré & Partner**
**Patentanwälte**
**Grafinger Strasse 2**
**81671 München (DE)**

(54) **Electromagnetic wave shielding laminate for displays and process for producing the same**

(57) A thin, electromagnetic wave shielding laminate for displays, thin, light, excellent in flexibility, improved in resistance of its near-infrared cutting function to ultraviolet ray, heat and moisture, needing a simple production process, easily produced, excellent in productivity and easily attached to a display, and a process for producing the same. The thin, electromagnetic wave shielding laminate for displays with a mesh-shape electroconductive material having openings, which is provided, at least on one side, with an optical film via an adhesive layer to form a monolithic structure, wherein

(a) the optical film having a near-infrared cutting function is arranged on the display side from the mesh-shape electroconductive material, and
(b) the openings of said mesh-shape electroconductive material or the openings and surface layer section are filled or coated with a transparent resin composition satisfying a specific optical requirement, and the process for producing the same.

Figure 1

| | |
|---|---|
| 1 | Anti-reflection layer |
| 2 | Support film (PET) |
| 3 | Mesh-shape electroconductive material |
| 4 | Transparent resin composition |
| 5 | Support film (PET) |
| 6 | NIR film |
| 7 | Tackifier layer |

Figure 2

**Description**

The present invention relates to a thin, electromagnetic wave shielding laminate for displays, e.g., a laminate to be put on a front face of a plasma display or the like, and process for producing the same, more particularly an electromagnetic wave shielding laminate for displays, thin, light, excellent in flexibility, improved in resistance of its near-infrared cutting function to ultraviolet ray, needing a simple production process, easily produced and excellent in productivity, and a process for producing the same.

It is considered that harmful electromagnetic waves of non-ionizing radiation, e.g., micro and radio waves, are massively emitted from surfaces of various displays for computers, e.g., those for office and factory automation devices, and for games and TV sets. Recently, these electromagnetic waves have been pointed out to cause adverse effects on human health, and also have caused other problems, e.g., failure of devices hit by them.

More recently, plasma display panels (PDPs) as light-emitting or planar display panels have been attracting attention for their large size and high visibility. A PDP is strongly demanded to have a higher electromagnetic wave shielding function than the conventional display panel, e.g., cathode ray tube (CRT) or liquid-crystal display panel (LCD), because of its more intense electromagnetic waves leaked out of its surface. Moreover, it emits from its surface near-infrared ray, which is derived from luminescence of an inert gas, e.g., Ne or Xe gas, contained in the cell. The near-infrared ray has a wavelength close to operational wavelengths of remote controllers for various home electric devices, and hence may cause their malfunctions. Therefore, a PDP is also strongly demanded to have a function of sufficiently cutting the near-infrared ray. Still more, it is demanded to have a sufficient anti-reflection or anti-dazzling function to prevent problems, e.g., image flickering, viewed from improved image quality and visibility.

As discussed above, a PDP is strongly demanded to have various functions, e.g., electromagnetic wave shielding, near-infrared cutting, anti-reflection and anti-dazzling, depending on its purpose, type or the like. In order to satisfy these demands, the display panel has been provided with a front plate or filter having some of these functions, as required, on its front face. For example, an electromagnetic wave shielding laminate having an electromagnetic wave shielding function and visible ray transmitting capacity has been developed and commercialized as a front filter for displays, e.g., PDP, which generate electromagnetic waves.

The important characteristics which these electromagnetic wave shielding laminates are required to satisfy include their function of cutting near-infrared ray to prevent malfunctions of some devices, e.g., remote controller, as discussed above, in addition to a function of shielding electromagnetic waves. More recently, in particular, PDPs generate larger quantities of near-infrared ray as their brightness increases, with the result that they are required to have a higher near-infrared cutting function.

These electromagnetic wave shielding laminates have been also used for windows for spaces in which precision devices are placed, e.g., those in hospitals or laboratories, to protect these devices from electromagnetic wave from a cellular phone.

Various types of front plates or filters have been proposed for plasma display panels (PDPs) to satisfy these needs. They include a front plate for PDPs, comprising a transparent resin plate, e.g., acrylic resin plate, provided with an electroconductive material on one side or the like (see e.g., JP-A-H09-330666); and an electromagnetic wave shielding, light-transmittable window material with an electroconductive mesh placed between 2 transparent substrates and monolithically assembled with these substrates by an adhesive resin, wherein the transparent substrate is provided with a specific anti-reflection film on the surface (see e.g., JP-A-H11-74681).

Moreover, use of transparent, electroconductive films has been proposed to decrease weight of the electromagnetic wave shielding laminates. These laminates include an electromagnetic wave shielding film comprising a transparent, high-molecular-weight film provided with at least 2 thin, metallic films with silver as the major ingredient and at least one thin, electroconductive film with a metallic oxide as the major ingredient (see e.g., JP-A-2000-62082); transparent, electroconductive film comprising a transparent base provided, on one main plane, with thin, transparent films of high refractive index, composed of a metallic oxide or the like, and thin, silver-containing metallic films alternately (see e.g., JP-A-2001-47549); and low reflection, electroconductive laminate film comprising a transparent base material provided with a hard coat layer, transparent electroconductive layer and thin transparent film of a specific material, formed on the outer layer of the transparent electroconductive layer (see e.g., JP-A-2001-243841).

Other film-shaped ones with a mesh-shaped electroconductive material have been proposed, also to decrease weight of the electromagnetic wave shielding laminates. These laminates include an adhesive film having an electromagnetic wave shielding capacity and transparency, composed of a transparent plastic base material provided with a geometrical pattern of an electroconductive material on the surface, wherein there is a specific difference in refractive index between the adhesive for coating the geometrical pattern and transparent plastic material or the like (see e.g., JP-A-H10-41682); transparent, electromagnetic wave shielding body comprising a transparent, high-molecular-weight film provided, at least on one side, with an adhesive material layer 1 and patterned electroconductive layer in this order to form a laminate film, and a transparent, high-molecular-weight reinforcing body to which the laminate film is bonded by an adhesive material layer 2, wherein at least one of the adhesive material layers 1 and 2 is incorporated with a near-infrared cutting material and colorant having a color-adjusting relation to the near-infrared cutting material, and at least one ultraviolet cutting layer to prevent deterioration of the near-infrared cutting material (see e.g., JP-A-2000-59074); and laminate comprising a transparent, high-molecular-weight film laminated with a metallic layer of copper foil on the main plane by a transparent adhesive, wherein the metallic layer is etched to have a specific pattern and thereby to have an opening ratio in a specific range (see e.g., JP-A-2001-217589).

However, these conventional electromagnetic wave shielding laminates proposed so far involve problems of being thick and heavy, because they have a panel protecting function and transparent base of glass, acrylic plate or the like. Therefore, they have been required to be thinner and lighter.

Moreover, electromagnetic wave shielding capacity and good visible ray transmittance for the transparent, electroconductive film tend to run counter to each other. It is therefore difficult to obtain an electromagnetic wave shielding laminate which can simultaneously satisfy these properties.

Moreover, an electromagnetic wave shielding laminate with a mesh-shaped electroconductive material needs to include another layer having a near-infrared cutting function, which is held by, e.g., dispersing a colorant capable of absorbing near-infrared ray in the transparent resin. This type of laminate involves a problem of deteriorated near-infrared cutting function when used for extended periods, because of insufficient resistance of the colorant to ultraviolet ray, heat and moisture.

It is an object of the present invention to solve the problems involved in the conventional electromagnetic wave shielding laminate or the like, and provide an electromagnetic wave shielding laminate for displays, thin, light, excellent in flexibility, improved in resistance of its near-infrared cutting function to ultraviolet ray, heat and moisture, needing a simple production process, easily produced, excellent in productivity and simply set in a display, and a process for producing the same.

The inventors of the present invention have noted, after having extensively studied to solve the above problems for a film-shape electromagnetic wave shielding laminate with a mesh-shape electroconductive material, light stability (resistance to ultraviolet ray) of the near-infrared absorbing colorant which provides the laminate with a near-infrared cutting function as the essential characteristic, and also noted a layered structure of the film-shape electromagnetic wave shielding laminate to reduce its weight, to find that the electromagnetic wave shielding laminate can be lighter and thinner, and deterioration of its near-infrared cutting function, in particular that of the near-infrared absorbing colorant, can be prevented by incorporating an ultraviolet absorber or the like in the transparent resin of hot-melt adhesive serving as a filler (or coating material) for openings of the mesh-shape electroconductive material to control ratio of an average transmittance in a specific ultraviolet wavelength range to total light transmittance in a certain range, and also by arranging the film layer containing the near-infrared absorbing colorant on the display side from the mesh-shape electroconductive material. The present invention has been developed, based on the above findings.

The first aspect of the present invention is a thin, electromagnetic wave shielding laminate for displays with a mesh-shape electroconductive material having openings which is provided, at least on one side, with an optical film via an adhesive layer to form a monolithic structure, wherein

(a) the optical film having a near-infrared cutting function is arranged on the display side from the mesh-shape electroconductive material, and
(b) the openings of the mesh-shape electroconductive material or the openings and surface layer section are filled or coated with a transparent resin composition satisfying the optical requirement described below:

$$Tu/Tt = 0.001 \text{ to } 0.2$$

wherein, Tt is total light transmittance, and Tu is an average transmittance in a wavelength range of 350 to 380nm.

The second aspect of the present invention is the thin, electromagnetic wave shielding laminate of the first aspect for displays, wherein the transparent resin composition is composed of a hot-melt adhesive and ultraviolet absorber.

The third aspect of the present invention is the thin, electromagnetic wave shielding laminate of the second aspect for displays, wherein the hot-melt adhesive is composed of an ethylene/vinyl acetate copolymer-based resin or ethylene/acrylic acid ester copolymer-based resin.

The fourth aspect of the present invention is the thin, electromagnetic wave shielding laminate of the second aspect for displays, wherein the ultraviolet absorber is at least one type selected from the group consisting of a benzotriazole- and benzophenone-based one, and incorporated at 1 to 10% by weight based on the whole transparent resin composition.

The fifth aspect of the present invention is the thin, electromagnetic wave shielding laminate of one of the first to fourth aspects for displays, wherein the optical film has at least one type of function selected from the group consisting of electromagnetic wave shielding, anti-reflection and anti-dazzling function, in addition to the near-infrared cutting function.

The sixth aspect of the present invention is the thin, electromagnetic wave shielding laminate of one of the first to fifth aspects for displays, wherein the near-infrared cutting function is provided by a near-infrared absorbing colorant or this colorant and a colorant having a color-adjusting relation thereto, incorporated in the transparent base polymer.

The seventh aspect of the present invention is the thin, electromagnetic wave shielding laminate of one of the first to sixth aspects for displays, wherein the laminate is 0.05 to 2mm thick.

The eighth aspect of the present invention is a process for producing the thin, electromagnetic wave shielding laminate of one of the first to seventh aspects for displays, wherein the mesh-shape electroconductive material is thermocompression-bonded to the adjacent optical film via at least one adhesive layer selected from the group consisting of a hot-melt adhesive film of transparent resin composition satisfying the optical requirement described below, and adhesive layer of the hot-melt adhesive film and a tackifier layer to form a monolithic structure:

$$Tu/Tt = 0.001 \text{ to } 0.2$$

wherein, Tt is total light transmittance, and Tu is an average transmittance in a wavelength range of 350 to 380nm.

The ninth aspect of the present invention is the process of the eighth aspect for producing the thin, electromagnetic wave shielding laminate for displays, wherein the thermocompression bonding is carried out at 80 to 120°C.

Figure 1 outlines the cross-sectional view of the thin, electromagnetic wave shielding laminate of the present invention for displays.

Figure 2 shows transmittance waveform of the NIR films (6) for the laminates prepared in EXAMPLE and COMPARATIVE EXAMPLE at each wavelength.

Figure 3 shows the transmittance waveform of the laminate prepared in EXAMPLE at each wavelength before and after the UV irradiation test.

Figure 4 shows the transmittance waveform of the laminate prepared in COMPARATIVE EXAMPLE at each wavelength before and after the UV irradiation test.

Figure 5 outlines the cross-sectional view of one embodiment of the assembly in which the thin, electromagnetic wave shielding laminate of the present invention for displays is used.

Figure 6 outlines the cross-sectional view of another embodiment of the assembly in which the thin, electromagnetic wave shielding laminate of the present invention for displays is used.

Description of Reference Numerals and Signs

1    Anti-reflection layer
2    Support film
3    Mesh-shape electroconductive material
4    Transparent resin composition
5    Support film
6    NIR film
7    Tackifier or adhesive layer

The present invention is described in detail for each item.

1. Mesh-shape electroconductive material

Mesh-shape electroconductive material for the thin, electromagnetic wave shielding laminate of the present invention for displays works as an electromagnetic wave shielding material, and is not limited so long as it has an electromagnetic wave shielding function.

The mesh-shape electroconductive materials useful for the present invention include an electroconductive fiber and metallic mesh body.

The electroconductive fiber mesh for the present invention is preferably composed of a light, highly durable and flexible fabric of metallized fibers. The process for producing the fabric of metallized fibers is not important in itself, and any fabric can be used for the present invention, irrespective of process by which it is produced.

Of these fabrics of metallized fibers, those suitable for the present invention as the highly durable and flexible electroconductive materials include an electroconductive cloth, e.g., fabric of synthetic fibers (e.g., polyester fibers) surface-treated with resin and then electrolessly plated with an electroconductive metal (e.g., copper or nickel) to 15 to 30% by weight; and electroconductive mesh, e.g., mesh of synthetic fibers (e.g., polyester fibers) electrolessly plated with an electroconductive metal (e.g., copper, silver or nickel) and then blackening-treated.

The fibers for the electroconductive mesh normally have a diameter of 10 to 60$\mu$m, and mesh size is preferably in a range from 40 to 200 meshes, where the mesh size is determined by a JIS standard sieve.

The metals useful for the electroconductive mesh of metallic fibers or metallized fibers include copper, stainless steel, aluminum, nickel, titanium, tungsten, tin, lead, iron, silver, chromium and alloys thereof. Carbon can be also used for the mesh. Of these, copper, nickel, stainless steel and aluminum are more preferable.

The organic materials for the mesh of metallized fibers include polyester, nylon, vinylidene chloride, Aramid, vinylon and cellulose.

The processes for producing the electrocon ductive metallic mesh include printing a lattice pattern with an electroconductive ink or the like on the transparent resin film, e.g., polyester film; forming a lattice pattern by etching on a thin, metallic film of copper, silver, aluminum or the like formed on a transparent resin film. Another electroconductive metallic mesh useful for the present invention is a metallic foil of copper, silver, aluminum or the like, treated by plastic forming (e.g., rolling) to have a given thickness and then treated by, e.g., punching, to have a number of bores and made into a lattice pattern. The lattice pattern preferably has a line width of 5 to 50μm, thickness of 1 to 100μm and line pitch of 150 to 800μm, in consideration of its electromagnetic wave shielding capacity and transp arency.

The other electroconductive metallic meshes useful for the present invention include an etched mesh and mesh printed to be electroconductive.

The etched meshes include a metallic film etched to have a desired pattern, e.g., lattice or punched pattern, by photolithography. The metallic films include a transparent resin film of, e.g., polyethylene terephthalate (PET), polycarbonate (PC) or polymethyl methacrylate (PMMA), provided with a metallic film of, e.g., copper, aluminum, stainless steel or chromium, by evaporation or sputtering; and transparent resin film coated with a foil of the above metal by an adhesive. The adhesive is preferably an epoxy-, urethane or ethylene/vinyl acetate (EVA) copolymer-based one.

The metallic film is preferably blackening-treated beforehand on one or both sides. The metallic film can have a higher opening ratio than the mesh of electroconductive fibers, because shape of its electroconductive portion and line width can be freely designed by photolithography.

For printing the mesh to be electroconductive, a transparent resin film (e.g., of PET, PC or PMMA) can be printed with a mixture of metallic particles (e.g., of silver, copper, aluminum, nickel) or nonmetallic electroconductive particles (e.g., of carbon) and a binder (e.g., of epoxy-, urethane- EVA-, melamine-, cellulose- or acrylic-based one) to have a pattern, e.g., of lattice. by gravure or offset printing, or the like.

2. Transparent resin composition

In the present invention, the transparent resin composition for the openings of the mesh-shape electroconductive material or these openings and surface layer section is characterized by having a ratio of average transmittance in a wavelength range of 350 to 380nm (Tu) to total light transmittance (Tt), i.e., Tu/Tt ratio, of 0.001 to 0.2.

The transparent resin composition is not limited, so long as it satisfies the above optical requirement. For example, it may be a transparent resin having a high total light transmittance, incorporated with an ultraviolet absorber, or composed of a single component of transparent resin having an ultraviolet absorbing capacity.

The preferred embodiments for the present invention include a transparent resin having a high total light transmittance, incorporated with an ultraviolet absorber.

For the above optical requirement, total light transmittance (Tt) represents average transmittance in the visible light range (wavelength: 380 to 780nm), and average transmittance in a wavelength range of 350 to 380nm (Tu) represents average transmittance in the ultraviolet range. The ratio Tu/Tt is 0.001 to 0.2, inclusive. At a Tu/Tt ratio below 0.001, the resin composition may be too high in turbidity, whether it is incorporated with an ultraviolet absorber or itself has a high ultraviolet absorbing capacity, may suffer a problem of bleeding-out of an ultraviolet absorber, when it is used, or may have an impractically low transmittance. At a Tu/Tt ratio above 0.2, the ultraviolet absorbing capacity may not be secured to a required level, or the colorant in the near-infrared absorbing layer may be deteriorated.

The analytical procedure for determining the optical properties is described. Total light transmittance (Tt) is determined in accordance with JIS K-7136 using an analyzer (e.g., Nippon Denshoku Industries, NDH2000 with D65 as the light source), and average transmittance in a wavelength range of 350 to 380nm (Tu) by an analyzer (e.g., JASCO, V-530). More concretely, the transparent resin composition is dissolved in a volatile solvent (e.g., dichloromethane, carbon tetrachloride or tetrahydrofuran), dried and made into a film having a thickness of 100±10μm by the flow casting or casting method, and the film is analyzed by the above analyzer under specific conditions.

The openings of the mesh-shape electroconductive material or these openings and surface layer section are filled or coated with a transparent resin composition satisfying the optical requirement described below by, e.g., (1) coating the mesh-shape electroconductive material with the liquid, transparent resin composition beforehand to fill the voids, (2) incorporating the hot-melt adhesive described later during the laminating step for forming the electromagnetic wave shielding laminate, and filling the voids during the molding step, or (3) incorporating the tackifier described later during the laminating step for forming the electromagnetic wave shielding laminate, and filling the voids while it is being laminated. One or more of the above procedures can be selected as required for the specific materials used.

(1) Hot-melt adhesive

A hot-melt adhesive is one of the transparent resins having a high total light transmittance for the transparent resin composition described above. The hot-melt adhesive may be film, pellet or yarn shape, and the film shape is more preferable for the present invention to be used.

Film-shape hot-melt adhesives are commercially available as films adhesive under heating. They are represented by those of EVA (ethylene/vinyl acetate copolymer)-, polyamide-, polyurethane-, polyester-, olefin- and acrylic-based resin, among others.

The hot-melt adhesive is preferably transparent and elastic, e.g., that normally used as an adhesive for laminated glass. More specifically, the resins for the elastic film include ethylene-based copolymers, e.g., ethylene/vinyl acetate copolymer (EVA), ethylene/methyl acrylate copolymer (EMA), ethylene/(meth)acrylic acid copolymer, ethylene/ethyl (meth)acrylate copolymer (EEA), ethylene/methyl methacrylate copolymer (EMAM), ethylene/(meth)acrylic acid copolymer crosslinked by a metallic ion, partially saponified ethylene/vinyl acetate copolymer, carboxylethylene/vinyl acetate copolymer, ethylene/(meth)acrylic acid/maleic anhydride copolymer and ethylene/vinyl acetate/(meth) acrylate copolymer, where (meth)acrylic means acrylic or methacrylic. Other resins useful for the present invention include polyvinyl butyral(PVB), epoxy, acrylic, phenolic, silicon, polyester and urethane resin. However, polyethylene/vinyl acetate copolymer (EVA) is more preferable for its balanced properties and handleability. Moreover, PVB resin, which is used for laminated glass for automobiles for its resistance to impact and penetration, adhesion, transparency, and the like, is also suitable for the present invention. PVB resin preferably has a vinyl acetal unit of 70 to 95% by weight, vinyl acetate unit of 1 to 15% by weight, and average polymerization degree of 200 to 3000, more preferably 300 to 2500. It is used as a resin composition containing a plasticizer.

The hot-melt adhesive normally contains a base polymer (e.g., polyethylene-based copolymer, such as EVA), resin for improving tackiness (tackifier) and petroleum-based wax, among others, and may be further incorporated with an additive, e.g., ultraviolet absorber, infrared absorber, aging inhibitor, paint-processing aid or the like within limits not harmful to the object of the present invention. It may be further incorporated with a colorant, e.g., dye or pigment, or filler, e.g., carbon black, hydrophobic silica or calcium carbonate, or the like at an adequate content to adjust color tone of the filter itself.

Moreover, surface treatment of the intermediate adhesive layer, which is made into a sheet, with corona discharge, low-temperature plasma, electron beams or ultraviolet ray is effective for improving its adhesion.

The hot-melt adhesive is produced by kneading an adhesive resin with one or more additives described above by an extruder, roll or the like, and making the mixture into a sheet of given shape by calendering, rolling, T-die extrusion, inflation or the like. The film is embossed during the film-making step to prevent blocking and facilitate degassing while it is compression-bonded to the transparent resin film.

(2) Ultraviolet absorber

The transparent resin composition as one of the preferred embodiments for the present invention comprises a hot-melt adhesive and ultraviolet absorber. An ultraviolet absorber, when incorporated in the composition, can prevent deterioration of its near-infrared cutting function as its essential characteristic, in particular that of its near-infrared absorbing colorant.

The ultraviolet absorbers useful for the present invention may be inorganic or organic. The organic ultraviolet absorbers include benzotriazole-based compounds, e.g., 2-(2'-hydroxy-5'-t-butylphenyl)benzotriazole and 2-(2'-hydroxy-3',5'-di-t-butylphenyl)benzotriazole; benzophenone-based compounds, e.g., 2-hydroxy-4-methoxybenzophenone and 2-hydroxy-4-n-octyloxybenzophenone; and hydroxybenzoate-based compounds, e.g., phenyl salicylate, 4-t-butylphenyl salicylate, 2,5-t-butyl-4-hydroxybenzoic acid/n-hexadecyl ester and 2,4-di-t-butylphenyl-3',5'-di-t-butyl-4'-hydroxybenzoate. The inorganic ultraviolet absorbers include titanium oxide, zinc oxide, cerium oxide, iron oxide and barium sulfate.

The ultraviolet absorber preferably has a maximum absorption wavelength of 350 to 420nm at 50% transmittance, more preferably 350 to 380nm. At a wavelength lower than 350nm, it may have an insufficient ultraviolet shielding (absorbing) capacity. A wavelength higher than 420nm is also undesirable, because may cause excessive coloration of the transparent film. The specific examples of these ultraviolet absorbers include benzotriazole- and benzophenone-based compounds.

The ultraviolet absorber is incorporated at 1 to 10% by weight based on the whole transparent resin composition, preferably 3 to 7%.

(3) Tackifier

Incorporation of a tackifier during the laminating step for forming the electromagnetic wave shielding laminate of the present invention to fill its voids is one of the procedures for filling or coating the openings of the mesh-shape electroconductive material or these openings and surface layer section with the transparent resin composition satisfying the specific optical requirement, as discussed earlier.

A tackifier is a pressure-sensitive adhesive, normally in the form of semi-solid (highly viscous) liquid. It is tacky at room temperature, and works as an adhesive under pressure. In particular, a tackifier normally used for optical purposes, e.g., adhesion of an optical film to a transparent base material, e.g., glass or acrylic sheet, is preferable. It is not limited, so long as it is excellent in resistance to weather and transparency, among others.

The tackifiers (pressure-sensitive adhesives) useful for the present invention include thermoplastic elastomer-based ones, e.g., acrylic-based resin, styrene/butadiene/styrene block polymer (SBS) and styrene/ethylene/butylene/styrene block polymer (SEBS), of which an acrylic-based tackifier is more preferable for its high resistance to weather and transparency.

The tackifier may be incorporated with ultraviolet absorber, colored pigment, colored dye, aging inhibitor, adhesion-imparting agent or the like, as required. It may be spread or put on an adhesive surface of the optical film beforehand to a thickness of 5 to 100μm, to put the film on the mesh-shape electroconductive material or another film. It is normally diluted with a solvent or emulsified to decrease its viscosity, spread on a surface of the object to be made adhesive, and then treated by evaporation to remove solvent, or moisture or the like for drying.

The tackifier is a semisolid (highly viscous) liquid, showing a proper adhesive power under pressure even at room temperature. However, it can have a still higher adhesive strength under heating.

3. Optical film

The optical film for the thin, electromagnetic wave shielding laminate of the present invention for displays shall have at least one type of function selected from the group consisting of near-infrared cutting, electromagnetic wave shielding, anti-reflection and anti-dazzling function. Moreover, it preferably has a color-adjusting function.

The optical film having these functions may comprise a single, multi-functional film, or laminate of two or more films each having one function. Number of films for the laminate is not limited.

The optical film serving as the outermost layer for the present invention may comprise a single, optical film or laminate of two or more optical films.

(1) Optical film having a near-infrared cutting function

There are various types of optical films having a near-infrared cutting function, e.g., a thin film formed on a transparent base film by evaporation of a near-infrared reflecting material (e.g., silver) or near-infrared absorbing material (e.g., near-infrared absorbing colorant or metallic oxide); film composed of a transparent base polymer dispersed with the near-infrared absorbing colorant or metallic oxide by kneading or the like; and near-infrared absorbing resin layer formed on a transparent base film by casting a uniform dispersion of resin in which the near-infrared absorbing colorant or metallic oxide is dissolved in the presence of a solvent and by removing the solvent from the coating layer. The film is not limited, so long as it has a near-infrared cutting function. Of these, more preferable for the present invention is the optical film composed of a transparent base polymer dispersed with the near-infrared absorbing colorant or metallic oxide by kneading or the like one.

The metallic oxides useful for the present invention include tin-doped indium oxide (ITO) and antimony-doped tin oxide (ATO).

(2) Near-infrared absorbing colorant

The near-infrared absorbing colorants useful for the present invention include phthalocyanine-, naphthalocyanine-, diimmonium-, polymethine- and anthraquinone-based ones, and metallic complexes with dithiol and azo compounds.

In the electromagnetic wave shielding laminate for displays, which includes an optical film comprising a transparent base polymer dispersed with a near-infrared absorbing colorant by kneading or the like to have a near-infrared cutting function, the mesh-shape electroconductive material preferably has a total visible light transmittance of 45% or more and transmittance in a wavelength range of 800 to 1100nm of 30% or less. The laminate with the electroconductive material satisfying the above optical properties can securely prevent malfunctions of remote controllers while keeping sufficient visibility for display front filters. The visible light means the light having a wavelength of 450 to 650nm.

(3) Optical film having a color-adjusting function

The method for imparting a color-adjusting function to the optical film is not limited. These methods include dispersing a colorant in a base film, e.g., polyester or polycarbonate film; coating or laminating a base film, e.g., polyester or polycarbonate film, with a base polymer (e.g., polyethylene terephthalate (PET)) dispersed beforehand with a colorant or the like; and incorporation of a color-adjusting dye or pigment in a tackifier.

Moreover, one of the preferred embodiments for realizing a color-adjusting function for the present invention is use of an optical film comprising a base polymer of polyethylene terephthalate (PET) or the like dispersed beforehand with a near-infrared absorbing colorant and color-adjusting colorant simultaneously.

The color-adjusting colorants useful for the present invention include Kayaset Blue N, Kayaset Violet AR and Kayaset Red B (Nippon Kayaku).

(4) Base polymer

The transparent base polymers in which a near-infrared absorbing or color-adjusting colorant is dispersed include polyester, acrylic, methacrylic, polycarbonate, urethane, silicone and phenolic resin, and homopolymer and copolymer of (meth)acrylic acid ester. Of these, acrylic and polyester resin are more preferable for the present invention.

(5) Base film

The base film for the optical film is not limited. The films useful for the present invention include those of polyester-, acrylic-, cellulose-, polyethylene-, polypropylene-, polyolefin-, polyvinyl chloride-, polycarbonate-, phenol- and urethane-based resin. Of these, a polyester resin film is more preferable for the present invention, in particular for its transparency and resistance to environment.

(6) Optical film having an anti-reflection or anti-dazzling function

The method for imparting an anti-reflection or anti-dazzling function to the optical film is not limited, and a known one may be used. The portion at which the function is to be provided is not limited. However, it is preferably provided on the surface of the base film (e. g., of polyester or triacetyl cellulose), where it can be exhibited more efficiently. The film provided with an anti-reflection and/or anti-dazzling function may be referred to as an AR (anti-reflection) film.

When the base film (e.g., of polyester or triacetyl cellulose) is laminated with a layer for the near-infrared shielding function and another layer for the anti-reflection and/or anti-dazzling function, it may be provided with one layer on one side and the other layer on the opposite side.

The methods for imparting the anti-reflection function to the optical film include laminating a layer of low-refractive material (e.g., magnesium fluoride or silicon oxide), and laminating a multi-layered anti-reflection layer composed of a layer of low-refractive material and another layer of high-refractive material (e.g., titanium oxide, tantalum oxide, tin oxide, indium oxide, zirconium oxide or zinc oxide). It is particularly preferable for the present invention to include a multi-layered anti-reflection layer composed of a layer of indium oxide and tin oxide (ITO layer) and another layer of silicon oxide, or multi-layered anti-reflection layer composed of at least 2 layers of silicon oxide and titanium oxide, the former being preferable for its still higher anti-reflection effect, and high surface hardness and adhesion, whereas the latter being preferable for high transparency, low cost, and high surface hardness and adhesion.

On the other hand, the method for imparting the anti-dazzling function to the optical film is not limited. For example, the function can be realized by laminating a layer having fine irregularities on the surface, provided by dispersing fine particles in a high-molecular-weight coating layer.

The high-molecular-weight coating layers preferable for the present invention include, but not limited to, those of resin produced by hardening a multi-functional monomer, and silicone-based crosslinkable resin, melamine-based crosslinkable resin and epoxy-based crosslinkable resin hardened under heating or with ultraviolet ray.

For the fine particles, which form irregularities on the surface to reduce its gloss, finely powdered inorganic compounds are suitably used.

These fine particles normally have a particle diameter of 0.002 to 20μm. They are incorporated preferably at 1 to 15 parts by weight per 100 parts by weight of the polymerizable compound incorporated.

The inorganic compound for the fine particles is not limited. The suitable compounds are oxides, e.g., silicon dioxide, aluminum oxide, magnesium oxide, tin oxide, silicon monoxide, zirconium oxide and titanium oxide. Of these, fine particles of silica with silicon dioxide as the major ingredient is particularly suitable for its low cost and potential for narrowing particle size distribution. The commercial fine silica particle products include Syloid 72 (Fuji-Davison Chemical), Syloid 244 (Fuji-Davison Chemical), Mizukasil P527 (Mizusawa Industrial Chemicals) and Aerosil TT600 (Degussa). Agglomerated colloidal silica may be used as fine silica particles. The commercial colloidal products include Ludox AM (Du Pont), Xesol A200 (Bayer AG) and SNOWTEX-C (Nissan Chemical Industries).

(7) Optical film having an electromagnetic wave shielding function

The optical film having an electromagnetic wave shielding function, which can be used in combination with the mesh-shape electroconductive material for the present invention, can be produced by coating a resin film, e.g., polyester film, or the optical film described earlier with a transparent electroconductive film to have electroconductivity.

The methods for forming an transparent electroconductive film on an optical film include forming at least one transparent electroconductive layer of metal and/or metallic oxide on the film by vacuum evaporation or sputtering, and coating the film with a resin dispersed with fine, electroconductive particles of metal and/or metallic oxide.

The metals useful for the present invention include gold, silver, platinum, palladium, copper, titanium, chromium, molybdenum, nickel and zirconium, of which silver is particularly preferable because it gives an electroconductive layer of higher conductivity, and reflects light in the near-infrared wavelength range and has a near-infrared cutting function. The metallic layer, when used as the electroconductive layer, is preferably multi-layered with a dielectric layer for preventing reflection from the metallic layer. The dielectric layers useful for the present invention include those of various metallic oxides, nitrides and sulfides.

The metallic oxides useful for the present invention include silicon, titanium, tantalum, tin, indium, zirconium and zinc oxide, and complex oxide of indium and tin oxide.

These metals and metallic oxides may be used either individually or in combination.

The optical film for the thin, electromagnetic wave shielding laminate of the present invention for displays has at least one type of function selected from the group consisting of near-infrared cutting, electromagnetic wave shielding, anti-reflection, anti-dazzling function and color-adjusting function. One of the preferred embodiments comprises 2 transparent films (e.g., of polyester or triacetyl cellulose), one coated with an anti-reflection film having an anti-reflection function and the other with a near-infrared absorbing film having a near-infrared cutting function, where a color-adjusting colorant is dispersed in the base film (e.g., of polyester or polycarbonate), or a tackifier to be used is incorporated with a color-adjusting dye or pigment, in order to realize the color-adjusting function. The optical film having the above-described desired functions can cut near-infrared ray which may cause malfunctions of a remote controller or the like, and exhibit an anti-reflection characteristic to prevent reflection of external light and color-adjusting characteristic.

4. Structure of the thin, electromagnetic wave shielding laminate for displays, and others

One of the structural characteristics of the thin, electromagnetic wave shielding laminate of the present invention for displays is the mesh-shape electroconductive material having openings, which is provided, at least on one side, with an optical film via an adhesive layer to form a monolithic structure, wherein the optical film having a near-infrared cutting function is arranged on the display side from the mesh-shape electroconductive material.

Some of the specific structures of the thin, electromagnetic wave shielding laminate for displays are described.

(1) The thin, electromagnetic wave shielding laminate for displays comprising 1) an optical film having a near-infrared cutting function, 2) film adhesive under heating, 3) mesh-shape electroconductive material 4) transparent resin composition composed of a hot-melt adhesive and ultraviolet absorber and 5) AR film as the outermost layer in this order on the display side.

(2) The thin, electromagnetic wave shielding laminate for displays comprising 1) an optical film having a near-infrared cutting function, 2) mesh-shape electroconductive material 3) transparent resin composition composed of a hot-melt adhesive and ultraviolet absorber and 4) AR film as the outermost layer in this order on the display side.

(3) The thin, electromagnetic wave shielding laminate for displays comprising 1) an optical film having a near-infrared cutting function, 2) transparent resin composition composed of a hot-melt adhesive and ultraviolet absorber, 3) mesh-shape electroconductive material and 4) AR film as the outermost layer in this order on the display side.

(4) The thin, electromagnetic wave shielding laminate for displays comprising 1) an optical film having a near-infrared cutting function, 2) transparent resin composition composed of a hot-melt adhesive and ultraviolet absorber and 3) mesh-shape electroconductive material coated with a transparent resin as the outermost layer in this order from the display side.

(5) The thin, electromagnetic wave shielding laminate for displays comprising 1) an optical film having a near-infrared cutting function, 2) mesh-shape electroconductive material coated with a transparent resin and 3) AR film containing an ultraviolet absorber as the outermost layer in this order from the display side.

(6) The thin, electromagnetic wave shielding laminate for displays comprising 1) an optical film having a near-infrared cutting function and 2) AR film containing an ultraviolet absorber as the outermost layer in this order from the display side.

(7) The thin, electromagnetic wave shielding laminate for displays comprising 1) an optical film having a near-infrared cutting function, 2) film adhesive under heating, 3) mesh-shape electroconductive material 4) film adhesive under heating, 5) transparent, electroconductive film, 6) transparent resin composition (film adhesive under heating) composed of a hot-melt adhesive and ultraviolet absorber and 7) AR film as the outermost layer in this order from the display side.

(8) The thin, electromagnetic wave shielding laminate for displays comprising 1) an optical film having a near-infrared cutting function, 2) film adhesive under heating, 3) transparent, electroconductive film, 4) mesh-shape electroconductive material 5) transparent resin composition (film adhesive under heating) composed of a hot-melt adhesive and ultraviolet absorber and 6) AR film as the outermost layer in this order from the display side.

(9) The thin, electromagnetic wave shielding laminate for displays comprising 1) an optical film having a near-infrared cutting function, 2) film adhesive under heating, 3) transparent, electroconductive film, 4) transparent resin composition (film adhesive under heating) composed of a hot-melt adhesive and ultraviolet absorber, 5) mesh-shape electroconductive material and 6) AR film as the outermost layer in this order from the display side.

(10) The thin, electromagnetic wave shielding laminate for displays comprising 1) an optical film having a near-infrared cutting function, 2) transparent resin composition (film adhesive under heating) composed of a hot-melt adhesive and ultraviolet absorber, 3) mesh-shape electroconductive material and 4) AR film as the outermost layer in this order from the display side.

(11) The thin, electromagnetic wave shielding laminate for displays comprising 1) an optical film having a near-infrared cutting function, 2) transparent resin composition (film adhesive under heating) composed of a hot-melt adhesive and ultraviolet absorber, 3) mesh-shape electroconductive material, 4) film adhesive under heating and 5) AR film as the outermost layer in this order from the display side.

Thickness of the thin, electromagnetic wave shielding laminate of the present invention for displays is not limited- However, it is preferably 0.05 to 2mm, in consideration of decreased thickness and weight of the laminate. At below 0.05mm, strength of the electromagnetic wave shielding laminate may not be secured. Thickness beyond 2mm is also not desirable, because it is contrary to the decreased thickness as the object of the present invention.

5. Process for producing the thin, electromagnetic wave shielding laminate for displays

The process for producing the thin, electromagnetic wave shielding laminate of the present invention for displays bonds, under heating, the mesh-shape electroconductive material to the adjacent optical film via at least one adhesive layer of hot-melt adhesive film of transparent resin composition satisfying the optical requirement described below, or adhesive layer of the hot-melt adhesive film and a tackifier layer to form a monolithic structure:

$$Tu/Tt = 0.001 \text{ to } 0.2$$

wherein, Tt is total light transmittance, and Tu is an average transmittance in a wavelength range of 350 to 380nm.

The mesh-shape electroconductive material and optical film are fast bonded to each other into a monolithic structure under heating even at a relatively low temperature by putting in-between at least one adhesive layer of the hot-melt adhesive film or adhesive layer of the hot-melt adhesive film and a tackifier layer. They are fast bonded to each other, and sufficient adhesion durability can be secured.

Bonding temperature is 80 to 120°C, preferably 90 to 110°C. At above 120°C, thermal strain in each member increases, possibly leading to warp of the electromagnetic wave shielding laminate or malfunction of the optical film. At below 80°C, on the other hand, adhesion between the 2 members may be insufficient, possibly leading to separation of the optical film or the like.

Pressure for the thermocompression bonding is not limited. However, the monolithic structure can be formed normally at 0.1 to $20\text{kg/cm}^2$ on the plane. At a pressure below $0.1\text{kg/cm}^2$, adhesion between these members may be insufficient and surface smoothness may be also insufficient. At a pressure above $20\text{kg/cm}^2$, on the other hand, the hot-melt adhesive film may be excessively fluid to flow out of the bonded article, causing uneven thickness and deteriorated precision. As a result, the bonded article may be no longer as-designed. Viewed from this angle, more preferable pressure is 0.5 to $15\text{kg/cm}^2$, at which the members will be bonded to each other as-designed.

The optical film can be thermocompression-bonded to the electromagnetic wave shielding laminate by various methods, e.g., rolling, pressing, vacuum pressing, forming in a vacuum oven, high-frequency forming and supersonic forming, all under heating. Each method can be adopted for a specific purpose. Of these, pressing under heating is generally adopted, and can be suitably adopted.

Degassing by an adequate method is preferably carried out prior to the thermocompression bonding, to prevent presence of air in the laminate. The degassing can be carried out under pressure by a roll, flat press or the like for pressurization, or under a vacuum by a bag, oven or the like operating under a vacuum. These methods can be suitably adopted for the present invention.

In the thermocompression bonding, the bonded article is normally formed while being put between mirror-finished plates of metal, plastic, glass or the like. The plate is used for protecting the bonded article during the forming step.

As discussed above, the optical film is bonded under heating to the mesh-shape electroconductive material at relatively low temperature and pressure, to bring several advantages, e.g., controlled thermal strain of each member, controlled warp of the thin, electromagnetic wave shielding laminate for displays, and controlled separation of the optical film or the like as a result of temporal change. Heating at a relatively low temperature also controls heat-caused deterioration of the light-controlling coating layer for the anti-reflection or anti-dazzling optical film, controls softening of the base film, e.g., polyester film, and improves surface smoothness.

Moreover, a combination of the tackifier layer and hot-melt adhesive film can improve product yield, because unseen dust is captured by these layers. Use of the tackifier layer to put the hot-melt adhesive film beforehand can simplify the lamination process.

Still more, the thin, electromagnetic wave shielding laminate for displays can be made into a monolithic structure by one thermocompression bonding cycle, even when it is multi-layered, improving productivity and giving the product economically at a reduced cost.

EXAMPLE

The present invention is described by EXAMPLE by referring to the attached drawings, which by no means limits the present invention.

EXAMPLE 1

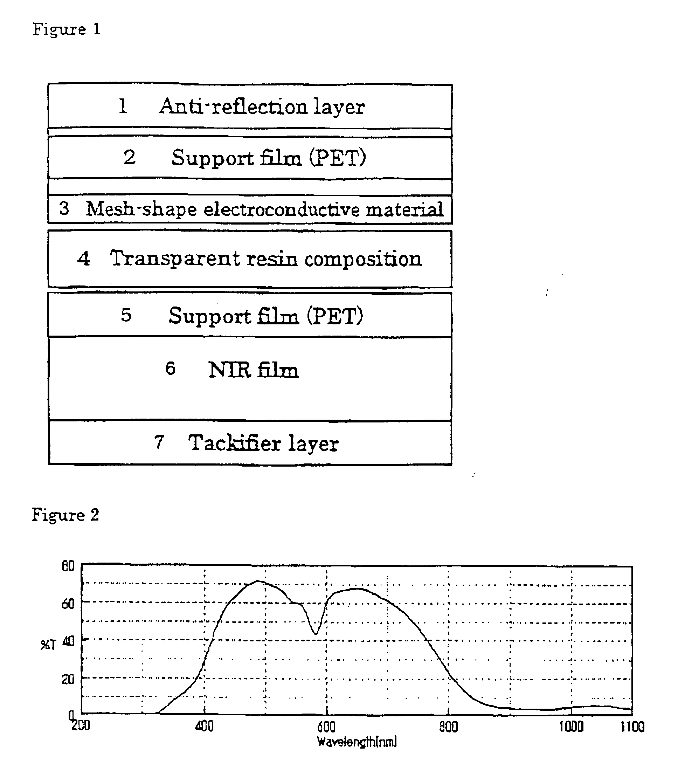

Thin, electromagnetic wave shielding laminate for displays, and process for producing the same (Figure 1)

Figure 1 outlines the cross-sectional view of the thin, electromagnetic wave shielding laminate of the present invention for displays.

Referring to Figure 1, the anti-reflection layer (1) was a laminate of transparent layers of different refractive index, and support film (2) as the optical film was of triacetyl cellulose (TAC) or polyethylene terephthalate (PET). More specifically, they were supplied by Sumitomo Osaka Cement (Clearance AR), in which the layer (1) and film (2) are bonded to each other into a monolithic structure, with the support film (2) being of PET and having a thickness of 100μm. The mesh-shape electroconductive material (3) was of copper foil, which may be formed on the support film (2). More specifically, the copper foil mesh had a line length of 20μm, pitch of 300μm and thickness of 18μm. The transparent resin composition (4) was composed of a hot-melt adhesive and ultraviolet absorber, the former containing an ethylene/vinyl acetate copolymer or ethylene/acrylic acid ester copolymer as the main ingredient, and had a Tu/Tt ratio of 0.001 to 0.2. More specifically, it was composed of "Melthene®-G" (Tosoh) and 1% by weight of an UV cutting agent (Johoku Chemical, JF78), made into a 100μm thick film by casting. The support film (5) was of triacetyl cellulose (TAC) or polyethylene terephthalate (PET). More specifically, it was of a 100μm thick PET film (Toyobo, COSMOSHINE A4300). The NIR film (6) was of a polycarbonate resin solution incorporated with a diimmonium colorant and dithiol nickel colorant, spread on the support film and dried, where 1,3-dioxolane was used as the solvent. It was responsible for near-infrared (NIR) absorbing, and frequently responsible for color adjusting or the like. Figure 2 shows transmittance waveform of the NIR film at each wavelength.

The tackifier or adhesive layer (7) was of an acrylic-based tackifier.

These layers (or films) were laminated and put between glass plates, and pressed at 1Kg/cm$^2$ and then heated at 100°C for 60 minutes, to prepare the thin, electromagnetic wave shielding laminate for displays.

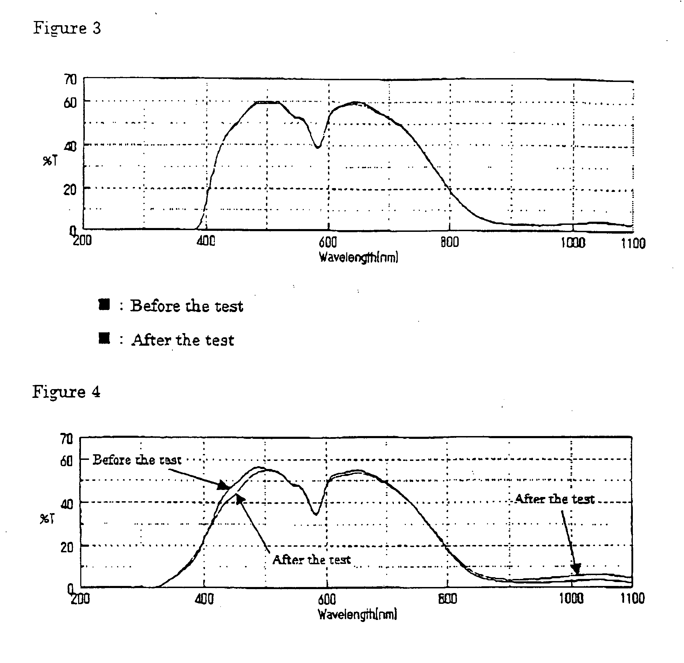

The electromagnetic wave shielding laminate was irradiated with ultraviolet ray, emitted from a xenon (Xe) lamp (100W/m$^2$) at 25°C and 60% RH for 4 hours. The results are given in Figure 3, which shows the transmittance waveform of the laminate at each wavelength before and after the UV irradiation test.

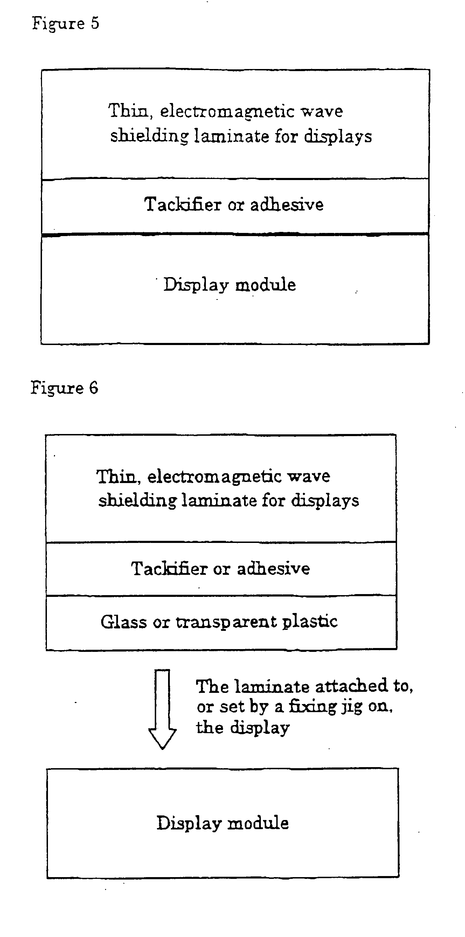

Figure 5 shows one embodiment of the assembly in which the thin, electromagnetic wave shielding laminate of the present invention for displays was used. It was directly attached to the display, to prepare a display module.

Figure 6 shows another embodiment of the assembly in which the thin, electromagnetic wave shielding laminate of the present invention for displays was used. It was attached to, or set by a fixing jig on, the display via a glass or transparent plastic plate, to prepare a display module.

COMPARATIVE EXAMPLE 1

A thin, electromagnetic wave shielding laminate for displays was prepared in the same manner as in EXAMPLE 1, except that the transparent resin composition (4) was composed of "Melthene®-G" (Tosoh) made into a 100μm thick film by casting, i.e., no UV cutting agent was used.

The electromagnetic wave shielding laminate was irradiated with ultraviolet ray, emitted from a xenon (Xe) lamp (100W/m$^2$) at 25°C and 60% RH for 4 hours. The results are given in Figure 4, which shows the transmittance waveform of the laminate at each wavelength before and after the UV irradiation test.

The thin, electromagnetic wave shielding laminates for displays, prepared in EXAMPLE and COMPARATIVE EXAMPLE, were irradiated with ultraviolet ray. It is found that the one prepared in COMPARATIVE EXAMPLE shows notable functional deterioration in the NIR region (increased transmittance), which is accompanied by a notably decreased transmittance in the 420 to 500nm region, whereas the one prepared in EXAMPLE shows little change both in the visible light and NIR regions, clearly indicating that it has a higher visible ray transmittance and resistance to ultraviolet ray.

The thin, electromagnetic wave shielding laminate of the present invention for displays brings notable effects of being light, thin, flexible, capable of being directly attached to the display, high in visible light transmittance, and resistant to ultraviolet ray, heat and moisture by including a mesh-shape electroconductive material having openings and provided, at least on one side, with an optical film via an adhesive layer to form a monolithic structure, wherein (a) the optical film having a near-infrared cutting function is arranged on the display side from the mesh-shape electroconductive material, and (b) the openings of the mesh-shape electroconductive material or the openings and surface layer section are filled or coated with a transparent resin composition satisfying a specific optical requirement.

It comprises members each resistant to deformation or warping, excellent in fabricability to have a monolithic structure, and can assemble all of the component members into a monolithic structure by one thermocompression bonding cycle, with the result that the process of the present invention is excellent in productivity and can give the laminate product economically at a reduced cost.

**Claims**

1. A thin, electromagnetic wave shielding laminate for displays with a mesh-shape electroconductive material having openings, which is provided, at least on one side, with an optical film via an adhesive layer to form a monolithic structure, wherein

(a) said optical film having a near-infrared cutting function is arranged on the display side from said mesh-shape electroconductive material, and

(b) said openings of said mesh-shape electroconductive material or said openings and surface layer section are filled or coated with a transparent resin composition satisfying the optical requirement described below:

$$Tu/Tt = 0.001 \text{ to } 0.2$$

wherein, Tt is total light transmittance, and Tu is an average transmittance in a wavelength range of 350 to 380nm.

2. The thin, electromagnetic wave shielding laminate according to Claim 1 for displays, wherein said transparent resin composition is composed of a hot-melt adhesive and ultraviolet absorber.

3. The thin, electromagnetic wave shielding laminate according to Claim 2 for displays, wherein said hot-melt adhesive is composed of an ethylene/vinyl acetate copolymer-based resin or ethylene/acrylic acid ester copolymer-based resin.

4. The thin, electromagnetic wave shielding laminate according to Claim 2 or 3 for displays, wherein said ultraviolet absorber is at least one type selected from the group consisting of a benzotriazole- and benzophenone-based one, and incorporated at 1 to 10% by weight based on the whole transparent resin composition.

5. The thin, electromagnetic wave shielding laminate according to one of Claims 1 to 4 for displays, wherein said optical film has at least one type of function selected from the group consisting of electromagnetic wave shielding, anti-reflection and anti-dazzling function, in addition to the near-infrared cutting function.

6. The thin, electromagnetic wave shielding laminate according to one of Claims 1 to 5 for displays, wherein said near-infrared cutting function is provided by a near-infrared absorbing colorant or this colorant and a colorant having a color-adjusting relation thereto, incorporated in the transparent base polymer.

7. The thin, electromagnetic wave shielding laminate according to one of Claims 1 to 6 for displays, wherein said laminate is 0.05 to 2mm thick.

8. A process for producing the thin, electromagnetic wave shielding laminate according to one of Claims 1 to 7, wherein said mesh-shape electroconductive material is thermocompression-bonded to said adjacent optical film via at least one adhesive layer selected from the group consisting of a hot-melt adhesive film of transparent resin composition satisfying the optical requirement described below, and adhesive layer of the hot-melt adhesive film and a tackifier layer to form a monolithic structure:

$$Tu/Tt = 0.001 \text{ to } 0.2$$

wherein, Tt is total light transmittance, and Tu is an average transmittance in a wavelength range of 350 to 380nm.

9. The process according to Claim 8 for producing said thin, electromagnetic wave shielding laminate for displays, wherein said thermocompression bonding is carried out at 80 to 120°C.

EP 1 413 425 A1

Figure 1

| 1 | Anti-reflection layer |
| 2 | Support film (PET) |
| 3 | Mesh-shape electroconductive material |
| 4 | Transparent resin composition |
| 5 | Support film (PET) |
| 6 | NIR film |
| 7 | Tackifier layer |

Figure 2

14

Figure 3

■ : Before the test

■ : After the test

Figure 4

Figure 5

```
+-----------------------------------------+
|                                         |
|   Thin, electromagnetic wave            |
|   shielding laminate for displays       |
|                                         |
+-----------------------------------------+
|                                         |
|       Tackifier or adhesive             |
|                                         |
+-----------------------------------------+
|                                         |
|                                         |
|        Display module                   |
|                                         |
|                                         |
+-----------------------------------------+
```

Figure 6

```
+-----------------------------------------+
|                                         |
|   Thin, electromagnetic wave            |
|   shielding laminate for displays       |
|                                         |
+-----------------------------------------+
|                                         |
|       Tackifier or adhesive             |
|                                         |
+-----------------------------------------+
|                                         |
|     Glass or transparent plastic        |
|                                         |
+-----------------------------------------+
```

The laminate attached to,
or set by a fixing jig on,
the display

```
+-----------------------------------------+
|                                         |
|                                         |
|         Display module                  |
|                                         |
|                                         |
+-----------------------------------------+
```

**European Patent Office**

# EUROPEAN SEARCH REPORT

Application Number

EP 03 02 3259

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| Y | EP 1 196 018 A (HASEGAWA CHEM IND ;NISSHIN SPINNING (JP)) 10 April 2002 (2002-04-10)<br>* figure 3; example 2 *<br>* paragraphs '0034!,'0050!,'0065! * | 1-9 | B32B3/10<br>H05K9/00 |
| Y | US 4 631 214 A (HASEGAWA HIROAKI)<br>23 December 1986 (1986-12-23)<br>* column 1, line 1-17 *<br>* column 4, line 3-13; figure 9 *<br>* column 8, line 39-51 * | 1-9 | |
| A | PATENT ABSTRACTS OF JAPAN<br>vol. 1999, no. 08,<br>30 June 1999 (1999-06-30)<br>& JP 11 074681 A (BRIDGESTONE CORP),<br>16 March 1999 (1999-03-16)<br>* abstract * | 1-9 | |
| A | PATENT ABSTRACTS OF JAPAN<br>vol. 2002, no. 11,<br>6 November 2002 (2002-11-06)<br>& JP 2002 188423 A (KIORITZ CORP),<br>5 July 2002 (2002-07-05)<br>* abstract * | 1-7 | TECHNICAL FIELDS SEARCHED (Int.Cl.7)<br><br>B32B<br>H05K |
| A | PATENT ABSTRACTS OF JAPAN<br>vol. 2000, no. 01,<br>31 January 2000 (2000-01-31)<br>& JP 11 298186 A (HITACHI CHEM CO LTD),<br>29 October 1999 (1999-10-29)<br>* abstract * | 8,9 | |

The present search report has been drawn up for all claims

| Place of search | Date of completion of the search | Examiner |
|---|---|---|
| THE HAGUE | 5 January 2004 | Stabel, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

  ...............................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 03 02 3259

This annex lists the patent family members relating to the patent documents cited in the above-mentioned European search report.
The members are as contained in the European Patent Office EDP file on
The European Patent Office is in no way liable for these particulars which are merely given for the purpose of information.

05-01-2004

| Patent document cited in search report | | Publication date | Patent family member(s) | | Publication date |
|---|---|---|---|---|---|
| EP 1196018 | A | 10-04-2002 | JP | 2002116700 A | 19-04-2002 |
| | | | EP | 1196018 A1 | 10-04-2002 |
| | | | TW | 521562 B | 21-02-2003 |
| | | | US | 2002042162 A1 | 11-04-2002 |
| US 4631214 | A | 23-12-1986 | JP | 1724156 C | 24-12-1992 |
| | | | JP | 2060497 B | 17-12-1990 |
| | | | JP | 61225014 A | 06-10-1986 |
| | | | JP | 61151258 A | 09-07-1986 |
| | | | DE | 3545790 A1 | 31-07-1986 |
| JP 11074681 | A | 16-03-1999 | US | 6090473 A | 18-07-2000 |
| | | | US | 6262364 B1 | 17-07-2001 |
| JP 2002188423 | A | 05-07-2002 | US | 2002073952 A1 | 20-06-2002 |
| JP 11298186 3 | A | | NONE | | |

EPO FORM P0459

For more details about this annex : see Official Journal of the European Patent Office, No. 12/82